# FASCICULE DE BREVET EUROPEEN

(11) **EP 3 325 694 B1**
(45) Date de publication et mention de la délivrance du brevet: **01.04.2020**
(21) Numéro de dépôt: 16757283.3
(22) Date de dépôt: 19.07.2016
(51) Int. Cl.: C25D 9/12, A47J 36/02, B05D 5/08, C23C 14/08, C25D 15/00, C23C 18/12, C23C 4/11

(54) **ARTICLE CULINAIRE COMPRENANT UNE COUCHE D'OXYDE DE TERRE RARE**
KÜCHENARTIKEL MIT EINER SELTENERDOXIDSCHICHT
CULINARY ITEM INCLUDING A RARE-EARTH OXIDE LAYER

(30) Priorité: 21.07.2015 FR 1556895
(43) Date de publication de la demande: 30.05.2018
(73) Titulaire: SEB S.A., 69130 Ecully (FR)
(72) Inventeur: POLESEL MARIS, Jérôme, 54135 Mexy (FR); CAILLIER, Laurent, 74370 Pringy (FR); DUBANCHET, Aurélien, 73100 Gresy Sur Aix (FR)
(74) Mandataire: Soares, Luis Filipe
(86) Numéro de dépôt international: PCT/FR2016/051857
(87) Numéro de publication internationale: WO 2017/013351

(56) Documents cités:
- FR-A1- 2 968 016
- US-A1- 2014 178 641
- DATABASE WPI Week 199114 1991 Thomson Scientific, London, GB; AN 1991-098694 XP002758075, -& JP H03 43476 A (MATSUSHITA ELEC IND CO LTD) 25 février 1991 (1991-02-25)

## Description

La présente invention concerne de manière générale un article culinaire dont au moins l'une des faces est munie d'un revêtement comprenant au moins une couche d'oxyde de terre rare et de charges dispersées dans la matrice.

Actuellement, les différents revêtements utilisés dans les ustensiles culinaires de cuisson présentent chacun, en fonction de leur nature, des propriétés essentielles de performance, différentes en fonction de la nature du revêtement.

Ainsi, les revêtements à base de résine fluorocarbonée (par exemple à base de polytétrafluoroéthylène (PTFE)) présentent d'excellentes propriétés d'antiadhésivité, tandis que les revêtements à base d'émail ou de sol-gel (plus connus sous le nom de céramiques) présentent d'excellentes propriétés de dureté et de robustesse à des températures élevées (notamment supérieures à 400°C).

Cependant, il n'existe pas, à l'heure actuelle, un revêtement combinant l'ensemble de ces propriétés, ou du moins pas encore de manière optimisée.

Les revêtements antiadhésifs à base de résine fluorocarbonée peuvent dans une certaine mesure être optimisés contre l'abrasion, la rayure et le peluchage (délamination des couches), par exemple par l'adjonction de charges dans les formulations (exemples : SiO₂, TiO₂, Al₂O₃, SiC, BN, diamant, etc.) mais sans toutefois atteindre les performances mécaniques des revêtements à base d'émail ou de sol-gel.

Les propriétés d'antiadhésivité des revêtements à base de sol-gel peuvent dans une certaine mesure être optimisés par exemple par l'adjonction d'additifs de lubrification de type polydiméthylsiloxane mais sans toutefois atteindre les performances antiadhésives des revêtements à base de résine fluorocarbonée. En ce qui concerne les revêtements à base d'émail, leur niveau d'antiadhésivité reste faible quelles que soient les solutions techniques connues utilisées. Pour résoudre ce problème, la demanderesse a mis au point un revêtement comprenant au moins une couche d'oxyde de terre rare, les oxydes de terres rares ayant la particularité de présenter non seulement une dureté mécanique et une résistance à l'abrasion comparables à celles des émaux et céramiques, mais également d'excellentes propriétés intrinsèques d'hydrophobie permettant au revêtement obtenu de présenter une antiadhésivité comparable à celle des revêtements fluorocarbonés et adaptée à l'application culinaire.

L'utilisation d'oxyde de terre rare dans des revêtements céramiques est connue de l'homme du métier. Ainsi, le document brevet FR 2925063 concerne une couche céramique riche en oxydes de terres rares utilisée dans le domaine des condensateurs ou turbines à vapeur. Ce document décrit un substrat métallique recouvert d'une matière comprenant un oxyde primaire et un oxyde secondaire. L'oxyde primaire comprend du cérium et de l'hafnium et l'oxyde secondaire comprend un cation d'oxyde secondaire choisi dans l'ensemble comprenant les cations de terres rares, d'yttrium et de scandium.

Le revêtement de FR 2925063 permet d'obtenir des matières céramiques dotées d'une résistance relativement grande au mouillage par divers liquides tels que l'eau.

JP H 03-43476 décrit des ustensiles de cuisson avec un revêtement anti adhérent qui soit dur et résistant à la chaleur. La couche comprend un siloxane, de la poudre de verre, de particules de MoS2, BaF2 et CeO2. La présente invention a donc pour objet un article culinaire comprenant un support présentant une face intérieure pouvant recevoir des aliments et une face extérieure destinée à être disposée vers une source de chaleur, et un revêtement disposé sur au moins l'une des deux faces, caractérisé en ce que le revêtement comprend au moins une couche d'oxyde de terre rare, continue ou discontinue, comprenant une matrice d'au moins un oxyde de terre rare et des charges dispersées dans la matrice telles qu'indiquées dans la revendication 1.

Selon une alternative avantageuse de l'invention, la matrice d'oxyde de terre rare peut comprendre au moins un oxyde de lanthanide.

Selon une autre alternative avantageuse, la matrice d'oxyde de terre rare peut comprendre de l'oxyde de cérium, seul ou en mélange avec au moins un autre oxyde de lanthanide.

L'incorporation d'oxyde de cérium dans la matrice d'oxyde de terre rare confère à la couche d'oxyde de terre rare l'effet de barrière (anticorrosion, antioxydation, imperméabilité aux liquides et gaz).

Cet effet barrière résulte de la propriété hydrophobique de l'oxyde de cérium (communément appelé cérine) qui a notamment pour effet de le rendre insoluble dans l'eau.

La couche d'oxyde de terre rare comprend en outre des charges dispersées dans ladite matrice, lesdites charges êtant choisies dans le groupe comprenant les résines fluorocarbonées, les polyétheréthercétones (PEEK), les polyéthercétones (PEK), les polyimides (PI), les polyamide-imides (PAI), les polyéthersulfones (PES), les polysulfures de phénylène (PPS), les billes silicones, et leurs mélanges.

Ce type d'adjonction a pour effet d'améliorer, voire de supprimer, les problèmes liés à la fracturation de la couche d'oxyde de lanthanide par effet de dissipation d'énergie mécanique. Ce type d'adjonction n'altère pas le caractère hydrophobe de la couche d'oxyde de terre rare.

Préférentiellement, les charges peuvent comprendre une résine fluorocarbonée qui peut être choisie dans le groupe comprenant le PTFE, le PTFE modifié, les copolymères de tétrafluoroéthylène et de perfluoropropylvinyléther (PFA), les copolymères de tétrafluoroéthylène et d'hexafluoropropène (FEP) et leurs mélanges.

Dans le cadre de la présente invention, les charges peuvent préférentiellement être présentes en une teneur comprise entre 0,1 et 50 % en poids par rapport au poids total sec de la couche d'oxyde de terre rare. La teneur en charges ne doit pas excéder 50 % en poids afin de conserver les propriétés physicochimiques de l'oxyde de cérium.

De manière avantageuse, l'épaisseur de la couche d'oxyde de terre rare peut être comprise entre 0,1 et 50 µm. Il est à noter que l'épaisseur des couches d'oxyde de terre rare dépend du procédé d'application utilisé.

Par ailleurs, il est préférable que les charges ne fassent pas saillie. En effet, si des charges faisaient saillie, notamment dans le cas de charges non fluorées, les propriétés d'antiadhésivité du revêtement pourraient être diminuées.

Préférentiellement, la surface de la couche d'oxyde de terre rare peut être structurée ou texturée.

Une structuration de la surface de la couche d'oxyde de terre rare permet avantageusement de réduire la mouillabilité de la surface d'oxyde de terre rare et donc d'obtenir une couche d'oxyde de terre rare superhydrophobe.

Par couche superhydrophobe, on entend, au sens de la présente invention, une surface qui présente un angle de contact avec une goutte d'eau supérieur à 150°.

Au sens de la présente invention, on entend par surface structurée ou texturée, une surface caractérisée par un relief ou une rugosité contrôlé et maitrisé.

D'une manière avantageuse, le support peut être en matériau métallique, en verre, en céramique, en terre cuite ou en plastique.

De préférence, le support peut être métallique et peut être en aluminium ou alliage d'aluminium, anodisé ou non, éventuellement poli, brossé, sablé ou microbillé, ou en acier éventuellement poli, brossé, sablé ou microbillé, ou en acier inoxydable éventuellement poli, brossé, sablé ou microbillé, ou en fonte d'acier, d'aluminium ou de fer, ou en cuivre éventuellement martelé ou poli.

Préférentiellement, le support peut être métallique et peut comprendre une alternance de couches en métal et/ou en alliage métallique, ou est une calotte d'aluminium de fonderie, d'aluminium ou d'alliages d'aluminium doublée d'un fond extérieur en acier inoxydable.

Selon un mode de réalisation de la présente invention, le revêtement peut comprendre en outre, disposée sur la couche d'oxyde de terre rare, au moins une couche comprenant au moins une résine fluorocarbonée, seule ou en mélange avec une résine d'accroche thermostable et résistante à une température supérieure à 200°C, cette ou ces résines formant un réseau continu fritté.

Avantageusement, dans ce mode de réalisation, la résine fluorocarbonée peut être choisie dans le groupe comprenant le PTFE, le PTFE modifié, les copolymères de tétrafluoroéthylène et de perfluoropropylvinyléther (PFA), les copolymères de tétrafluoroéthylène et d'hexafluoropropène (FEP), et leurs mélanges.

Préférentiellement, dans ce mode de réalisation, la résine d'accroche peut être choisie parmi les polyamides imides (PAI), les polyéthers imides (PEI), les polyamides (PI), les polyéthercétones (PEK), les polyétheréthercétones (PEEK), les polyéthersulfures (PES), les sulfures de polyphénylène (PPS), et leurs mélanges.

Ces résines d'accroche ont l'avantage d'être thermostables et résistantes à une température supérieure à 200°C.

A titre d'exemples non limitatifs d'articles culinaires conformes à la présente invention, on citera notamment des articles culinaires tels que les casseroles et les poêles, les woks et les sauteuses, les crêpières, les grills, les moules et plaques pour la pâtisserie, les plaques et grilles de barbecue.

L'article culinaire selon la présente invention peut être préparé par n'importe quelle méthode adéquate connue de l'homme du métier. La couche d'oxyde de terre rare peut notamment être appliquée par pulvérisation pyrolyse, par pulvérisation thermique, par la technique PVD (dépôt en phase vapeur), par voie sol-gel, ou encore par électrochimie et frittage.

Il est à noter que le composé de départ pour l'application de la couche d'oxyde de terre rare peut se présenter sous deux formes :
- soit sous forme de poudre d'oxyde de terre rare pure, ou mélangée avec d'autres matériaux également sous forme de poudre,
- soit sous forme de dispersion d'oxyde de terre rare colloïdale stabilisée dans un milieu aqueux ou solvanté,
- soit sous forme d'une solution de précurseurs de sels de terres rares du type nitrate, acétate, acétylacétonate, chlorure ou ammonium dans de l'eau, un alcool ou un ester.

Une telle solution de précurseurs peut comprendre en outre un ou plusieurs additifs. Ce ou ces additifs peuvent notamment être un acide tel que l'acide acétique, l'acide citrique ou encore l'acide tartrique. Ces acides permettent d'agir en tant que complexant sur les précurseurs de sels, et notamment sur les précurseurs de sels de terres rares. L'introduction de tels additifs dans la solution de précurseurs peut ainsi permettre d'obtenir un réseau d'oxyde de terre rare régulier et dense, limitant ainsi la formation de porosité dans la matrice de la couche.

Une application par pulvérisation pyrolyse comprend la pulvérisation ou la nébulisation sous forme de gouttelettes d'une solution de précurseurs de sels de terres rares vers au moins une des faces d'un article culinaire maintenue à haute température, idéalement supérieure à 350°C. La température de la face de l'article est maintenue à un seuil permettant la pyrolyse du sel de terre rare avant son contact avec la face pour générer un oxyde de terre rare adhérant sur la face sous forme de nanoparticules. Le dépôt par pulvérisation pyrolyse permet de générer une couche d'oxyde de terre rare par effet additif.

Une post-cuisson de l'article à plus haute température que la température utilisée lors du dépôt de la couche permet éventuellement d'améliorer la cristallinité et la densité de la couche d'oxyde de terre rare (à titre d'exemple, la post-cuisson peut être réalisée à une température supérieure à 400°C) .

Une application par pulvérisation thermique (ou projection thermique) est réalisée à une température suffisante pour permettre la fusion de l'oxyde de terre rare qui se présente sous forme d'une poudre d'oxyde de terre rare pure ou mélangée avec d'autres matériaux également sous forme de poudre, ou bien sous forme d'une solution de précurseurs de sels de terres rares.

Dans le cas où le composé de départ est sous forme de poudre fine d'oxyde de terre rare, il est injecté au plus près de la flamme ou de la torche. La chaleur à cœur produite (idéalement > 2500°C) permet la fusion des grains composant la poudre d'oxyde, le flux continuel de gaz combustible ou ionisé alimentant la torche permettant en parallèle d'induire une projection avec une énergie cinétique suffisante des grains en fusion pour les projeter sur la surface d'un article culinaire, les faire adhérer et générer ainsi de proche en proche une couche dense.

En lieu et place de la poudre, un composé de départ de type précurseurs de sels de terres rares en solution peut aussi être injecté au niveau de la torche plasma ou du spray flamme mais dans une zone de moindre température pour initier la pyrolyse des sels de terres rares et projeter ceux-ci sur la surface de l'article culinaire pour réaliser une couche d'oxyde de terre rare. L'oxydation est provoquée par l'oxygène ambiant pour une torche plasma atmosphérique.

Le spray thermique, ou projecteur thermique, dans le cadre de la présente invention, peut être une torche plasma utilisant une composition de gaz porteurs ionisés de type argon/hydrogène Ar/H₂, ou un spray de type flamme ou HVOF utilisant une composition de gaz comburant/carburant de type oxygène/acétylène.

A titre d'exemple, le spray thermique par torche plasma permet de générer une température à cœur de l'ordre de 15000°C. Au cours de la projection par spray thermique, la surface de l'article culinaire est maintenue à une température de 200°C à 350°C pour améliorer la cinétique d'étalement et d'adhérence des particules d'oxyde en fusion lors de leur impact sur la surface. Par effet cumulatif, des couches de plusieurs microns, voire plusieurs dizaines de microns peuvent être générées ainsi.

Comme mentionné ci-dessus, des charges sont dispersées dans la couche d'oxyde de terre rare. Ces charges peuvent notamment être introduites sous forme d'une dispersion de particules polymériques (dans une solution de précurseurs de sels de terres rares) ou sous forme de poudre sèche (dans une solution de précurseurs de sels de terres rares ou dans la poudre comprenant l'oxyde de terre rare).

Le composé de départ comprenant des charges, le procédé d'application de la couche d'oxyde de terre rare doit être optimisé afin de ne pas provoquer la dégradation thermique totale des charges durant l'application.

Avantageusement, comme mentionné ci-dessus, la couche d'oxyde de terre rare peut être structurée (ou texturée). Cette structuration peut être obtenue, par exemple, par embossage de la surface du support d'un article culinaire, par gravure chimique ou physique de la surface du support d'un article culinaire préalablement recouvert d'une résine portant le motif à reproduire, cette résine étant de préférence photoréticulable.

### EXEMPLES

exemples 5,8 et 9 sont selon l'invention; les exemples 1-4, 6,7, 10 sont pas selon l'invention.

### EXEMPLE 1 : Préparation et application par pulvérisation pyrolyse d'une couche d'oxyde de cérium

La composition de précurseurs est préparée comme suit :
- on dilue de l'acétate de cérium (Ce(OOCCH₃)₃.H₂O) dans un mélange eau:éthanol avec un rapport en volume de 70:30 ;
- puis, on agite la solution pendant 36 h à température ambiante afin d'obtenir une solution transparente sans précipités, ayant une concentration en cérium de 0,02 mol/L.

L'application par pulvérisation pyrolyse de cette composition est réalisée de manière répétée sur la surface d'un échantillon en acier inoxydable. Ces applications sont réalisées au moyen d'un pistolet ou d'un nébuliseur en maintenant l'échantillon à une distance d'environ 20 cm du pistolet ou du nébuliseur, la surface de l'échantillon étant maintenue à une température supérieure à 350°C pour cristalliser le dépôt sous forme solide d'oxyde de cérium à la surface de l'échantillon.

L'application répétée de 10 à 20 cycles de pulvérisation permet de former une couche solide d'oxyde de terre rare ayant une épaisseur submicrométrique, comprise entre 100 et 400 nm.

### EXEMPLE 2 : Préparation et application par pulvérisation pyrolyse d'une couche d'oxyde de cérium

Par le même procédé qu'à l'exemple 1, une couche d'oxyde de terre rare est appliquée à partir d'une composition de précurseurs préparée en ajoutant de la L-proline comme agent de chélation à du nitrate de cérium(III) hydraté (Ce(NO₃)₃.6H₂O) dans un rapport molaire 1:1.

### EXEMPLE 3 : Préparation et application par pulvérisation pyrolyse d'une couche d'oxyde de cérium

Une composition de précurseurs est préparée en diluant du chlorure de cérium heptahydrate (CeCl₃.7H₂O) dans un mélange eau:éthanol avec un rapport molaire de 3:1 pour obtenir une concentration en cérium comprise entre 0,05 et 0,025 mol/L.

Dans cet exemple de réalisation, le dépôt par pulvérisation se fait par le même procédé qu'à l'exemple 1 sur la surface d'un échantillon en verre maintenue à 400°C pour obtenir une couche d'oxyde de terre rare continue et homogène.

### EXEMPLE 4 : Préparation et application par pulvérisation thermique (ou projection thermique) d'une couche d'oxyde de cérium

La composition de précurseurs est préparée comme suit :
- on solubilise 75g de nitrate de cérium hexahydrate (Ce(NO₃)₃.6H₂O) dans 1,5 litres d'eau pure ;
- puis, on agite la solution pendant 20 min.

La composition de précurseurs est ensuite injectée dans une torche plasma paramétrée avec un flux de gaz porteur (de type mélange Ar/H₂) suffisant pour provoquer la pyrolyse des sels de cérium avant contact avec la surface d'un échantillon en aluminium.

Le cérium ainsi atomisé se retrouve oxydé sous forme d'oxyde de cérium sur la surface. De proche en proche, par effet additif, une couche d'oxyde de cérium est ainsi réalisée sur la surface de l'échantillon.

### EXEMPLE 5 : Préparation et application par pulvérisation thermique (ou projection thermique) d'une couche d'oxyde de cérium comprenant des charges de polymère fluoré

Une poudre est préparée en mélangeant de la poudre d'oxyde de cérium, avec une taille de grain comprise entre 30 et 70 microns, et de la poudre de PTFE (ou de PFA), avec une taille de grain comprise entre 10 et 50 microns.

La poudre est ensuite injectée dans une torche plasma paramétrée avec un flux de gaz porteur (de type mélange Ar/H₂) suffisant pour provoquer la pyrolyse de l'oxyde de cérium avant contact avec la surface d'un échantillon en aluminium. La distance de projection entre la torche et la surface de l'échantillon est de l'ordre de 125 mm et la poudre est pulvérisée avec une vitesse de déplacement linéaire de la torche plasma de l'ordre de 75 m/min.

La surface de l'échantillon sur laquelle est appliquée la poudre est maintenue à 300°C pour améliorer la cinétique de diffusion des grains d'oxyde de cérium en fusion et l'homogénéité de la couche d'oxyde de terre rare, comprenant des particules PTFE (ou de PFA).

La couche d'oxyde de terre rare ainsi générée atteint quelques dizaines de microns d'épaisseur.

### EXEMPLE 6 : Préparation et application par voie PVD d'une couche d'oxyde de cérium, sur un échantillon structuré

La couche d'oxyde de terre rare superhydrophobe est réalisée en deux étapes successives :
1) texturation de la surface d'un échantillon métallique de type aluminium, suivie d'un
2) dépôt par PVD de la couche d'oxyde de cérium hydrophobe sur la surface texturée de l'échantillon.

Il existe plusieurs variantes concernant l'étape 1), dite étape de texturation.

Par exemple, la première variante consiste à texturer la surface de l'échantillon en procédant à une gravure chimique de la surface (dépôt de résine photoréticulable / insolation via un masque adapté / ouverture des zones non insolées au solvant afin de créer le motif à reproduire), conduisant à la formation de plots à la surface de l'échantillon.

Le temps de gravure permet de contrôler la profondeur des motifs. Les plots mesurent 9 µm de large, sont espacés les uns des autres de 11 µm et sont profonds de 15 µm.

La deuxième variante consiste à texturer la surface de l'échantillon de façon aléatoire par attaque chimique.

Dans cette variante de réalisation, la surface de l'échantillon en aluminium est attaqué en voie acide de manière aléatoire de façon à obtenir les paramètres de rugosité suivants :
- Ra de 5 microns,
- Rq de 5 microns, et
- Rz de 25 microns.

La troisième variante de réalisation consiste à procéder à un embossage par matrice texturée de la surface de l'échantillon.

Dans cette variante, la surface de l'échantillon est texturée sous pression par une matrice dure texturée en nitrure de titane. Les plots reproduits mesurent 9 µm de large, sont espacés les uns des autres de 11 µm et sont profonds de 15 µm.

L'étape 2) est une étape de dépôt d'une couche continue d'oxyde de cérium, sur la surface texturée, par technologie PVD. Le dépôt est réalisé sous vide, via l'utilisation d'une cible d'oxyde de cérium frittée.

La couche ainsi obtenue mesure entre 50 nm (sur la surface texturée de manière aléatoire de la deuxième variante) et 500 nm d'épaisseur (sur la surface comprenant les plots des première et troisième variantes) et suit avec précision les contours de la texturation.

### EXEMPLE 7 : Préparation et application par voie sol-gel (alcoxydes) d'une couche d'oxyde de cérium

Du butoxyde de cérium est mélangé à du 2-butanol avec un ratio molaire de 0,1 ; de l'acétyl acétonate, jouant le rôle d'agent chélatant, est ensuite ajouté au mélange.

Puis, une solution aqueuse d'acide chlorhydrique concentrée à 1 mol/L est introduite, sous agitation, au goutte à goutte (notons que le ratio molaire butoxyde de cérium / acétyl acétonate est de 2, et celui du butoxyde de cérium / eau est de 0,5), et le sol ainsi obtenu est agité pendant 48 heures jusqu'à atteindre l'équilibre des réactions d'hydrolyse / condensation adéquat.

Un pigment noir inorganique, composé d'oxyde de cuivre chrome et fer, est ensuite ajouté à hauteur de 5 % en poids par rapport au poids total de la solution, et enfin, une charge alumine alpha est introduite, sous agitation, à hauteur de 4 % en poids par rapport au poids total de la solution.

Dans cet exemple de réalisation, une couche d'oxyde de cérium est réalisée par voie sol-gel, grâce à la réaction d'hydrolyse / condensation du butoxyde de cérium.

Pour ce faire, la solution obtenue, comme détaillé précédemment, est pulvérisée sur la surface d'un échantillon en aluminium qui a été préalablement sablée et dégraissée, la surface de l'échantillon étant portée à une température comprise entre 60°C et 80°C afin d'éviter les coulures et d'évacuer une partie des solvants durant l'enduction.

Afin d'obtenir une épaisseur adéquate tout en minimisant le risque de fissuration de la couche, un séchage d'une première couche est réalisé à 80°C pendant 5 minutes, avant de pulvériser une seconde couche de la même solution sol-gel sur l'échantillon.

Une pré-cuisson de la couche d'oxyde de terre rare est réalisée à 120°C pendant 10 minutes afin d'évacuer une majorité des solvants.

Enfin, l'ensemble échantillon et couche d'oxyde de terre rare subit un traitement thermique à 350°C afin de densifier le réseau d'oxyde de cérium.

La couche d'oxyde de terre rare obtenue présente une épaisseur de 15 µm, sans fissuration visible au microscope binoculaire.

### EXEMPLE 8 : Préparation et application par voie sol-gel (alcoxydes) d'une couche d'oxyde de terre rare comprenant des charges de polymère fluoré

On ajoute à la solution sol-gel de l'exemple 7, une poudre de PTFE à hauteur de 2 % en poids du poids total de la solution. Puis, on réalise une couche de cérium par voie sol-gel grâce à la réaction d'hydrolyse / condensation du butoxyde de cérium comme indiqué dans l'exemple 7.

Il est à noter que ces particules de PTFE ont pour effet d'améliorer les propriétés d'hydrophobie et d'antiadhérence de la couche d'oxyde de terre rare.

### EXEMPLE 9 : Préparation et application par voie sol-gel (sels) d'une couche d'oxyde de cérium comprenant des charges de polymère fluoré

Du nitrate de cérium est dissout dans de l'eau déminéralisée de façon à obtenir une concentration de 1 mol/L, puis de l'acide citrique pur à 99,5 % est ajouté, sous agitation, avec un ratio molaire nitrate de cérium / acide citrique de 0,5.

La solution est agitée pendant 1 heure à température ambiante, et un mélange constitué d'isopropanol et de poudre de PTFE (ratio massique 48/2) est ensuite ajouté à la solution dans un rapport volumique 1:1, afin d'améliorer la durée de vie du sol et d'introduire les charges fluorés qui augmenteront le caractère hydrophobe du revêtement.

Enfin, la solution est agitée pendant 24 heures jusqu'à obtenir un sol stable et translucide.

La solution obtenue est ensuite pulvérisée pour obtenir une couche d'oxyde de terre rare sur la surface d'un échantillon en aluminium lisse préalablement dégraissée, la surface de l'échantillon étant portée à une température comprise entre 40°C et 60°C afin d'éviter les coulures et d'évacuer une partie des solvants durant l'enduction.

Après un premier séchage à 100°C durant 10 minutes, l'échantillon en aluminium subit un traitement thermique à 380°C durant 30 minutes afin de condenser le réseau d'oxyde de cérium.

Une couche d'oxyde de cérium de 500 nm d'épaisseur est obtenue.

### EXEMPLE 10 : Préparation et application par voie électrochimique et frittage d'une couche d'oxyde de cérium

Un échantillon en aluminium lisse préalablement dégraissé est positionné sur l'électrode négative d'un système de dépôt électrochimique.

Les précurseurs Ce(NO₃)₃-6H₂O sont en solution aqueuse (0,1 mol/L) en présence d'ammoniaque NH3 à 5 % volumique.

La couche d'oxyde de terre rare à base d'hydroxyde de cérium est formée en 1 heure en appliquant, au système de dépôt électrochimique, un potentiel de 3 V.

La couche d'oxyde de terre rare à base d'hydroxyde de cérium amorphe est finalement oxydée sous air à 550°C pendant 5 heures pour donner un film de 0,5 microns d'épaisseur d'oxyde de cérium.

### RESULTATS DES TESTS REALISES

### Test d'hydrophobicité des revêtements obtenus

On évalue le caractère hydrophobe des revêtements réalisés selon les exemples précédents en mesurant l'angle de contact d'une goutte d'eau sur le revêtement avec un goniomètre de type Digidrop de GBX. Les résultats de ces mesures sont indiqués dans le tableau ci-dessous.

| **Exemples** | **Angle de contact (en °)** |
|---|---|
| 1 | 105 |
| 2 | 105 |
| 3 | 105 |
| 4 | 110 |
| 5 | 115 |
| 6 | 170 |
| 7 | 105 |
| 8 | 115 |
| 9 | 115 |
| 10 | 115 |

## Revendications

1. Article culinaire comprenant un support présentant une face intérieure pouvant recevoir des aliments et une face extérieure destinée à être disposée vers une source de chaleur, et un revêtement disposé sur au moins l'une des deux faces
ledit article culinaire étant **caractérisé en ce que** le revêtement comprend au moins une couche d'oxyde de terre rare comprenant une matrice d'au moins un oxyde de terre rare, et
**en ce que** la couche d'oxyde de terre rare comprend en outre des charges dispersées dans ladite matrice, lesdites charges étant choisies dans le groupe comprenant les résines fluorocarbonées, les polyétheréthercétones (PEEK), les polyéthercétones (PEK), les polyimides (PI), les polyamide-imides (PAI), les polyéthersulfones (PES), les polysulfures de phénylène (PPS), les billes silicones, et leurs mélanges.

2. Article culinaire selon la revendication 1, dans lequel ladite matrice comprend au moins un oxyde de lanthanide.

3. Article culinaire selon l'une quelconque des revendications précédentes, dans lequel ladite matrice comprend de l'oxyde de cérium, seul ou en mélange avec au moins un autre oxyde de lanthanide.

4. Article culinaire selon l'une quelconque des revendications précédentes, dans lequel les charges comprennent une résine fluorocarbonée choisie dans le groupe comprenant le polytétrafluoroéthylène (PTFE), le PTFE modifié, les copolymères de tétrafluoroéthylène et de perfluoropropylvinyléther (PFA), les copolymères de tétrafluoroéthylène et d'hexafluoropropène (FEP) et leurs mélanges.

5. Article culinaire selon l'une quelconque des revendications précédentes, dans lequel les charges sont présentes en une teneur comprise entre 0,1 et 50 % en poids par rapport au poids total sec de la couche d'oxyde de terre rare.

6. Article culinaire selon l'une quelconque des revendications précédentes, dans lequel l'épaisseur de la couche d'oxyde de terre rare est comprise entre 0,1 et 50 µm.

7. Article culinaire selon l'une quelconque des revendications précédentes, dans lequel la surface de la couche d'oxyde de terre rare est structurée.

8. Article culinaire selon l'une quelconque des revendications précédentes, dans lequel le support est en matériau métallique, en verre, en céramique, en terre cuite ou en plastique.

9. Article culinaire, selon la revendication 8, dans lequel le support est métallique et est en aluminium ou alliage d'aluminium, anodisé ou non, éventuellement poli, brossé, sablé ou microbillé, ou en acier éventuellement poli, brossé, sablé ou microbillé, ou en acier inoxydable éventuellement poli, brossé, sablé ou microbillé, ou en fonte d'acier, d'aluminium ou de fer, ou en cuivre éventuellement martelé ou poli.

10. Article culinaire, selon la revendication 8, dans lequel le support est métallique et comprend une alternance de couches en métal et/ou en alliage métallique ou est une calotte d'aluminium de fonderie, d'aluminium ou d'alliages d'aluminium doublée d'un fond extérieur en acier inoxydable.

11. Article culinaire selon l'une quelconque des revendications précédentes, dans lequel le revêtement comprend en outre, disposée sur la couche d'oxyde de terre rare, au moins une couche comprenant au moins une résine fluorocarbonée, seule ou en mélange avec une résine d'accroche thermostable et résistante à une température supérieure à 200°c, cette ou ces résines formant un réseau continu fritté.

12. Article culinaire selon la revendication 11, dans lequel la résine fluorocarbonée est choisie dans le groupe comprenant le polytétrafluoroéthylène (PTFE), le PTFE modifié, les copolymères de tétrafluoroéthylène et de perfluoropropylvinyléther (PFA), les copolymères de tétrafluoroéthylène et d'hexafluoropropène (FEP), et leurs mélanges.

13. Article culinaire, selon l'une quelconque des revendications 11 et 12, dans lequel la résine d'accroche est choisie parmi les polyamides imides (PAI), les polyéthers imides (PEI), les polyamides (PI), les polyéthercétones (PEK), les polyétheréthercétones (PEEK), les polyéthersulfures (PES), les sulfures de polyphénylène (PPS), et leurs mélanges.

## Patentansprüche

1. Kochartikel, umfassend einen Träger, der eine Innenseite, die Nahrungsmittel aufnehmen kann, und eine Außenseite vorweist, die dazu bestimmt ist, zu einer Wärmequelle hin angeordnet zu sein, und eine Beschichtung, die auf mindestens einer der beiden Seiten angeordnet ist,
wobei der Kochartikel **dadurch gekennzeichnet ist, dass** die Beschichtung mindestens eine Seltenerdoxidschicht umfasst, die eine Matrix aus mindestens einem Seltenerdoxid umfasst, und
dass die Seltenerdoxidschicht ferner in der Matrix dispergierte Füllstoffe umfasst, wobei die Füllstoffe aus der Gruppe ausgewählt sind, die Fluorkohlenstoffharze, Polyetheretherketone (PEEK) Polyetherketone (PEK), Polyimide (PI), Polyamidimide (PAI), Polyethersulfone (PES), Phenylenpolysulfide (PPS), Silikonperlen und Gemische davon umfasst.

2. Kochartikel nach Anspruch 1, wobei die Matrix mindestens ein Lanthanidoxid umfasst.

3. Kochartikel nach einem der vorhergehenden Ansprüche, wobei die Matrix Ceroxid allein oder im Gemisch mit mindestens einem anderen Lanthanidoxid umfasst.

4. Kochartikel nach einem der vorhergehenden Ansprüche, wobei die Füllstoffe ein Fluorkohlenwasserstoffharz umfassen, das aus der Gruppe ausgewählt ist, die Polytetrafluorethylen (PTFE), modifiziertes PTFE, Copolymere von Tetrafluorethylen und Perfluorpropylvinylether (PFA), Copolymere von Tetrafluorethylen und Hexafluorpropen (FEP) und Gemische davon umfasst.

5. Kochartikel nach einem der vorhergehenden Ansprüche, wobei die Füllstoffe in einem Gehalt zwischen 0,1 und 50 Gew.-% bezogen auf das Gesamttrockengewicht der Seltenerdoxidschicht vorliegen.

6. Kochartikel nach einem der vorhergehenden Ansprüche, wobei die Dicke der Seltenerdoxidschicht zwischen 0,1 und 50 µm liegt.

7. Kochartikel nach einem der vorhergehenden Ansprüche, wobei die Oberfläche der Seltenerdoxidschicht strukturiert ist.

8. Kochartikel nach einem der vorhergehenden Ansprüche, wobei der Träger aus metallischem Material, Glas, Keramik, Terrakotta oder Kunststoff ist.

9. Kochartikel nach Anspruch 8, wobei der Träger metallisch ist und aus Aluminium oder einer Aluminiumlegierung, das/die gegebenenfalls eloxiert oder nicht, poliert, gebürstet, sandgestrahlt oder mikrobestrahlt ist, oder aus Stahl, der gegebenenfalls poliert, gebürstet, sandgestrahlt oder mikrobestrahlt ist, oder aus Edelstahl, der gegebenenfalls poliert, gebürstet, sandgestrahlt oder mikrobestrahlt ist, oder aus Stahlguss, aus Aluminium oder aus Eisen oder aus Kupfer ist, das gegebenenfalls gehämmert oder poliert ist.

10. Kochartikel nach Anspruch 8, wobei der Träger metallisch ist und abwechselnde Schichten aus Metall und/oder Metalllegierung umfasst oder eine Kalotte aus Gussaluminium, Aluminium oder Aluminiumlegierungen ist, die mit einem externen Boden aus Edelstahl ausgekleidet ist.

11. Kochartikel nach einem der vorhergehenden Ansprüche, wobei die Beschichtung ferner auf der Schicht aus Seltenerdoxid angeordnet mindestens eine Schicht umfasst, die mindestens ein Fluorkohlenstoffharz allein oder in Gemisch mit einem thermostabilen und über 200 °C temperaturbeständigen Haftharz umfasst, wobei dieses oder diese Harze ein kontinuierliches gesintertes Netz bilden.

12. Kochartikel nach Anspruch 11, wobei das Fluorkohlenwasserstoffharz aus der Gruppe ausgewählt ist, die Polytetrafluorethylen (PTFE), modifiziertes PTFE, Copolymere von Tetrafluorethylen und Perfluorpropylvinylether (PFA), Copolymere von Tetrafluorethylen und Hexafluorpropen (FEP) und Gemische davon umfasst.

13. Kochartikel nach einem der Ansprüche 11 und 12, wobei das Haftharz aus Polyamidimiden (PAI), Polyetherimiden (PEI), Polyamiden (PI), Polyetherketonen (PEK). Polyetheretherketonen (PEEK), Polyethersulfiden (PES), Polyphenylensulfiden (PPS) und Gemischen davon ausgewählt ist.

## Claims

1. Culinary article comprising a support having an inner face able to receive food and an outer face intended to be disposed towards a source of heat, and a coating disposed on at least one of the two faces
said culinary article being **characterised in that** the coating comprises at least one layer of rare-earth oxide comprising a matrix of at least one rare-earth oxide, and
**in that** the layer of rare-earth oxide further comprises fillers dispersed in said matrix, said fillers being chosen from the group comprising fluorocarbon resins, polyetheretherketones (PEEK), polyetherketones (PEK), polyimides (PI), polyamide-imides (PAI), polyethersulfones (PES), phenylene polysulfides (PPS), silicone beads, and mixtures thereof.

2. Culinary article according to claim 1, wherein said matrix comprises at least one lanthanide oxide.

3. Culinary article according to any of the preceding claims, wherein said matrix comprises cerium oxide, alone or in a mixture with at least one other lanthanide oxide.

4. Culinary article according to any of the preceding claims, wherein the fillers comprise a fluorocarbon resin chosen from the group comprising polytetrafluoroethylene (PTFE), modified PTFE, copolymers of tetrafluoroethylene and perfluoropropylvinylether (PFA), copolymers of tetrafluoroethylene and hexafluoropropene (FEP) and mixtures thereof.

5. Culinary article according to any of the preceding claims, wherein the fillers are present in a proportion of between 0.1% and 50% by weight with respect to the total dry weight of the layer of rare-earth oxide.

6. Culinary article according to any of the preceding claims, wherein the thickness of the layer of rare-earth oxide is between 0.1 and 50 µm.

7. Culinary article according to any of the preceding claims, wherein the surface of the layer of rare-earth oxide is structured.

8. Culinary article according to any of the preceding claims, wherein the support is made from metal material, glass, ceramic, terracotta or plastics material.

9. Culinary article according to claim 8, wherein the support is metal and is made from aluminium or aluminium alloy, anodised or not, optionally polished, brushed, sandblasted or microbead blasted, or from steel, optionally polished, brushed, sandblasted or microbead blasted, or from stainless steel, optionally polished, brushed, sandblasted or microbead blasted, or from cast steel, aluminium or iron, or from copper, optionally hammered or polished.

10. Culinary article according to claim 8, wherein the support is metal and comprises an alternation of metal and/or metal alloy layers or is a cap of cast aluminium, of aluminium or of aluminium alloys lined with an external base of stainless steel.

11. Culinary article according to any of the preceding claims, wherein the coating further comprises, disposed on the layer of rare-earth oxide, at least one layer comprising at least one fluorocarbon resin, alone or in a mixture with a thermostable bonding resin resistant to a temperature above 200°C, this resin or these resins forming a sintered continuous lattice.

12. Culinary article according to claim 11, wherein the fluorocarbon resin is chosen from the group comprising polytetrafluoroethylene (PTFE), modified PTFE, copolymers of tetrafluoroethylene and perfluoropropylvinylether (PFA), copolymers of tetrafluoroethylene and hexafluoropropene (FEP) and mixtures thereof.

13. Culinary article according to either claim 11 or claim 12, wherein the bonding resin is chosen from polyamide-imides (PAI), polyether-imides (PEI), polyamides (PI), polyetherketones (PEK), polyetheretherketones (PEEK), polyether sulfides (PES), polyphenylene sulfides (PPS), and mixtures thereof.
